# EUROPEAN PATENT APPLICATION

(11) **EP 4 421 863 A1**
(43) Date of publication of application: **28.08.2024**
(21) Application number: 21966088.3
(22) Date of filing: 03.12.2021
(51) Int. Cl.: H01L 21/8234, H10B 53/20, H01L 27/105, H01L 29/78

(54) **MEMORY AND ELECTRONIC DEVICE**

(71) Applicant: Huawei Technologies Co., Ltd., Shenzhen, Guangdong 518129 (CN)
(72) Inventor: ZHANG, Min, Shenzhen, Guangdong 518129 (CN); ZHAO, Jie, Shenzhen, Guangdong 518129 (CN); ZHANG, Heng, Shenzhen, Guangdong 518129 (CN); YANG, Xichao, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: Isarpatent
(86) International application number: PCT/CN2021/135364
(87) International publication number: WO 2023/097662

(57) **Abstract**

A memory and an electronic device are disclosed, relate to the field of storage technologies, and can reduce an area of a storage cell and improve storage density. The memory includes a first transistor (T1) that is in a front end of line. One of a source and a drain of the first transistor (T1) is a first electrode and the other is a second electrode. The memory further includes a first capacitor (C1) and a word line (WL). The first capacitor is electrically connected to the first electrode of the first transistor. The word line (WL) and a metal gate (G) of the first transistor are of an integrated structure and are located at a same layer.

## Description

### TECHNICAL FIELD

This application relates to the field of storage technologies, and in particular, to a memory and an electronic device.

### BACKGROUND

Storage cells of a ferroelectric random access memory (ferroelectric random access memory, FeRAM) include a 1T1C (one transistor one capacitor) storage cell, a 2T2C (two transistor one capacitor) storage cell, and a 2T1C (two transistor two capacitor) storage cell. At present, how to reduce an area of a storage cell, and increase an area percentage of a ferroelectric capacitor, to implement high-density storage are issues to be addressed when a general design rule is satisfied.

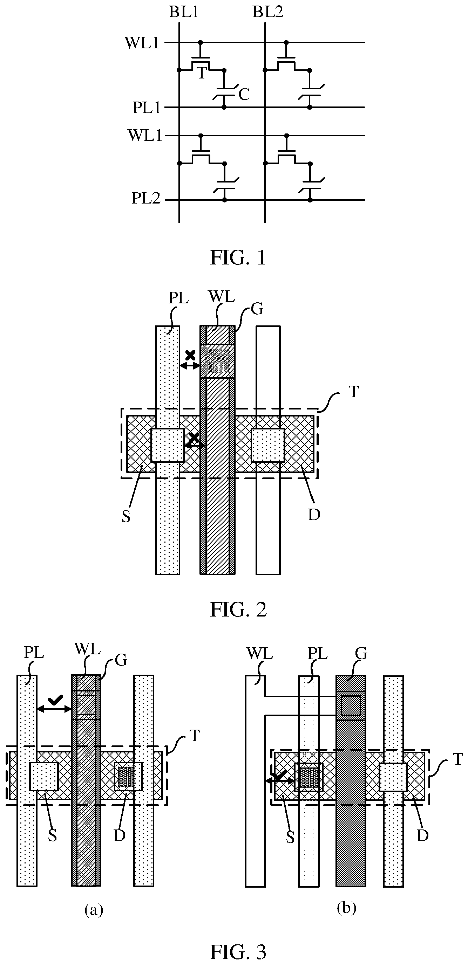

FIG. 1 shows a FeRAM storage circuit according to a related technology. A storage cell in the storage circuit is of a 1T1C structure. In other words, the storage cell includes one transistor T and one ferroelectric capacitor C. FIG. 2 is a layout design of a part of a film layer of the storage cell corresponding to FIG. 1. Refer to FIG. 2. As a process size is reduced, a gate (G) length of a transistor is reduced, and vias of a source/drain (S/D) cannot accommodate a metal line (for example, a bit line WL) connected to a gate G.

On this basis, a solution is provided in the related technology. Refer to (a) in FIG. 3. Metal lines (for example, plate lines PLs) connected to vias of a source/drain (S/D) are moved outwards, to satisfy a design rule of a bit line WL. Another solution is further provided in the related technology. Refer to (b) in FIG. 3. A bit line WL is moved to an outer side of vias of a source/drain (S/D), to satisfy a design rule of the bit line WL. However, the two solutions both cannot implement high storage density due to a limitation of a design rule of the vias of the source/drain (S/D).

### SUMMARY

Embodiments of this application provide a memory and an electronic device, to reduce an area of a storage cell and improve storage density.

This application provides a memory. The memory includes a first transistor that is in a front end of line. One of a source and a drain of the first transistor is a first electrode and the other is a second electrode. The memory further includes a first capacitor and a word line. The first capacitor is electrically connected to the first electrode of the first transistor. The word line and a metal gate of the first transistor are of an integrated structure and are located at a same layer.

In the memory, the metal gate is used for the transistor, the word line is directly disposed at a metal gate layer, and the word line does not need to be disposed at a metal layer that is in a back end of line, thereby avoiding a case in which the word line is connected to the gate of the first transistor through a metal via, and reducing arrangement density of metal lines in metal layers that are in the back end of line. In this way, it is necessary to ensure only that sizes of vias enclosed by metal layers in which a plate line and a bit line are respectively located and that are in the back end of line are minimum sizes that satisfy a design rule, so that an area of a storage cell can be reduced, and an area percentage of a ferroelectric capacitor can be increased, thereby implementing high-density storage.

In some possible implementations, the memory further includes a plurality of metal layers that are in a back end of line. The memory is provided with a bit line and a plate line. The bit line and the plate line are distributed at different metal layers of the plurality of metal layers, and a metal layer in which the plate line is located is closer to the front end of line than a metal layer in which the bit line is located. The second electrode of the first transistor is connected to the bit line through a metal via. The first electrode of the first transistor is connected to a bottom electrode of the first capacitor through a contact hole, and a top electrode of the first capacitor is connected to the plate line through a metal via.

In this case, the plate line is located in a metal layer below the bit line. For manufacturing the plate line, it is necessary to manufacture a metal trench at a position corresponding to a source/drain of a transistor, so that metal lines in the metal layer in which the plate line is located are arranged densely and with a large area. Therefore, in an x direction (namely, a width direction of the plate line), the size of the via enclosed by the metal layer needs to be the minimum size that satisfies the design rule, to avoid impact of a spacing, in the design rule, between the metal line and the via on a size of the storage cell. Similarly, in the x direction, the size of the via enclosed by the metal layer (namely, a first metal layer below a second metal layer) in which the bit line is located needs to be the minimum size that satisfies the design rule.

In some possible implementations, the memory further includes a plurality of metal layers that are in a back end of line. The memory is provided with a bit line and a plate line, the bit line and the plate line are distributed at different metal layers of the plurality of metal layers, and a metal layer in which the bit line is located is closer to the front end of line than a metal layer in which the plate line is located. The second electrode of the first transistor is connected to the bit line through a metal via. The plate line is connected to a top electrode of the first capacitor through a metal via formed in the metal layer in which the plate line is located, and the first electrode of the first transistor is connected to a bottom electrode of the first capacitor through a metal via.

In this case, the metal layer in which the bit line is located is below the metal layer in which the plate line is located, and the plate line is directly connected to the capacitor through the metal via formed in the metal layer in which the plate line is located. In this case, the capacitor is located above the bit line, a size of the capacitor is not limited by another metal line, and the plate line is located above the bit line. Therefore, an advantage of flexible wiring is achieved, without a need to additionally design a size of a via, so that the area of the storage cell can be reduced, and the area percentage of the ferroelectric capacitor can be increased, thereby implementing high-density storage.

In some possible implementations, the memory further includes a second transistor and a second capacitor. One of a source and a drain of the second transistor is a first electrode and the other is a second electrode. The second capacitor is electrically connected to the first electrode of the first transistor; and the second electrode of the second transistor is the second electrode of the first transistor.

Embodiments of this application further provide a memory. The memory includes a plurality of first transistors that are in a front end of line and disposed in parallel, and one of a source and a drain of the first transistor is a first electrode and the other is a second electrode. The memory further includes a plurality of first capacitors, and the first electrode of each first transistor is connected to one of the first capacitors. Gates of the first transistors are made of a polysilicon material; and the gates of the plurality of first transistors disposed in parallel are connected through a same gate line, and the gate line and the gates of the first transistor are of an integrated structure and are located at a same layer. The memory is provided with a word line in a back end of line. The gate line is connected to the word line through a plurality of first metal vias, two adjacent first metal vias are spaced by N first transistors, and N is a positive integer greater than or equal to 2.

In the memory, the gates of the transistors are made of the polysilicon material. The gate line is disposed at a polysilicon layer of the gates to connect the gates of the transistors in a same column. A metal gate line is disposed at a metal layer that is in the back end of line. The gate line and the gate line are connected through the metal vias that are spaced by a plurality of transistors. The word line and the gate line are connected in parallel as a signal line. Therefore, there is no need to provide a metal via at a position corresponding to each transistor for connection, that is, some vias are omitted, so that in a y direction (namely, an extension direction of the word line), an area occupied by the some vias is omitted, and the area of the storage cell is reduced.

In some possible implementations, N is less than or equal to 512, so that it can be ensured that while the area of the storage cell is reduced, a parallel circuit formed by the word line and the gate line has a small resistive-capacitive delay (RC delay).

In some possible implementations, the memory further includes a plurality of metal layers that are sequentially disposed and that are in the back end of line. The memory is provided with a bit line and a plate line. The bit line, the plate line, and the word line are distributed at different metal layers of the plurality of metal layers. A metal layer in which the plate line is located is closer to the front end of line than a metal layer in which the word line is located, and a metal layer in which the bit line is located is between the metal layer in which the plate line is located and the metal layer in which the word line is located. The second electrode of the first transistor is connected to the bit line through a metal via. The first electrode of the first transistor is connected to a bottom electrode of the first capacitor through a contact hole, and a top electrode of the first capacitor is connected to the plate line through a metal via.

In this case, the plate line is located in a metal layer below the bit line, and the word line is located in a metal layer above the bit line. In this case, metal lines are arranged densely and with a large area in the metal layer in which the plate line is located, and a size of a via enclosed by the metal layer needs to be a minimum size that satisfies a design rule, to avoid impact of a spacing, in the design rule, between the metal line and the via on a size of the storage cell. Similarly, in the x direction, a size of a via enclosed by a metal layer below the plate line needs to be the minimum size that satisfies the design rule.

In some possible implementations, the memory further includes a plurality of metal layers that are in the back end of line. The memory is provided with a bit line and a plate line. The bit line, the plate line, and the word line are distributed at different metal layers of the plurality of metal layers. A metal layer in which the bit line is located is closer to the front end of line than a metal layer in which the plate line is located, and a metal layer in which the word line is located is between the metal layer in which the bit line is located and the metal layer in which the plate line located. The second electrode of the first transistor is connected to the bit line through a metal via. The plate line is connected to a top electrode of the first capacitor through a metal via formed in the metal layer in which the plate line is located, and the first electrode of the first transistor is connected to a bottom electrode of the first capacitor through a metal via.

In this case, the word line is located in a metal layer above the bit line, and the plate line is located in a metal layer above the word line. In the y direction, at the metal layer in which the bit line is located, a trench or the like needs to be punched at a position corresponding to a source/drain of a transistor, so that metal lines are arranged densely. Therefore, in the y direction, a size of a via enclosed by the metal layer in which the bit line is located needs to be a minimum size that satisfies a design rule. In the x direction, at the metal layer in which the word line is located, a trench needs to be punched at a position corresponding to the source/drain of the transistor. Therefore, in the x direction, a size of a via enclosed by the metal layer in which the word line is located needs to be a minimum size that satisfies the design rule. The plate line is located on an upper layer of the word line, so that an advantage of flexible wiring is achieved, without a need to additionally design a size of a via.

In some possible implementations, the memory further includes a second transistor and a second capacitor. One of a source and a drain of the second transistor is a first electrode and the other is a second electrode. The second capacitor is electrically connected to the first electrode of the first transistor; and the second electrode of the second transistor is the second electrode of the first transistor.

Embodiments of this application further provide an electronic device. The electronic device includes a printed circuit board and the memory provided in any one of the foregoing possible implementations. The memory is electrically connected to the printed circuit board.

### BRIEF DESCRIPTION OF DRAWINGS

FIG. 1 shows a storage circuit according to a related technology;
FIG. 2 is a schematic diagram of a layout of a storage cell according to a related technology;
FIG. 3 is a schematic diagram of layouts of two storage cells according to a related technology;
FIG. 4a is a schematic diagram of a structure of a memory according to an embodiment of this application;
FIG. 4b is a schematic diagram of a layout of a memory according to an embodiment of this application;
FIG. 5a is a schematic diagram of a structure of a memory according to an embodiment of this application;
FIG. 5b is a schematic diagram of a layout of a memory according to an embodiment of this application;
FIG. 6a is a schematic diagram of a structure of a memory according to an embodiment of this application;
FIG. 6b is a schematic diagram of a layout of a memory according to an embodiment of this application;
FIG. 6c shows a parallel equivalent circuit of a word line and a gate line in the memory in FIG. 6a;
FIG. 7a is a schematic diagram of a structure of a memory according to an embodiment of this application; and
FIG. 7b is a schematic diagram of a layout of a memory according to an embodiment of this application.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are merely some but not all embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and descriptions, and shall not be understood as indicating or implying relative importance, or indicating or implying a sequence. The terms such as "connected", "connection", and the like are used to express interworking or interaction between different components, and may include a direct connection or an indirect connection via another component. In addition, the terms "include", "have", and any variant thereof are intended to cover non-exclusive inclusion, for example, include a series of modules or units. For example, a method, system, product, or device is not necessarily limited to those steps or units expressly listed, but may include other steps or units not expressly listed or inherent to such a process, method, product, or device. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

It should be understood that in this application, "at least one (item)" means one or more and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

Embodiments of this application provide an electronic device. The electronic device includes a printed circuit board (printed circuit board, PCB) and a memory connected to the printed circuit board. The memory may be a capacitive memory such as a FeRAM (ferroelectric random access memory, ferroelectric random access memory) or a DRAM (dynamic random access memory, dynamic random access memory).

A form of the electronic device is not limited in this application. For example, the electronic device may be an electronic product such as a mobile phone, a tablet computer, a notebook computer, a vehicle-mounted computer, a smartwatch, or a smart band.

As a process size is reduced, in the memory, a size and a spacing of a transistor no longer constitute a limitation on a size of a storage cell. In this case, how to design a layout and a shape of an interconnection line and a via is particularly important. In embodiments of this application, new design solutions are respectively proposed for a memory for which a metal gate-based process node is used and a memory for which a polysilicon gate-based process node is used, to reduce an area of a storage cell, and increase an area percentage of a ferroelectric capacitor, thereby implementing high-density storage.

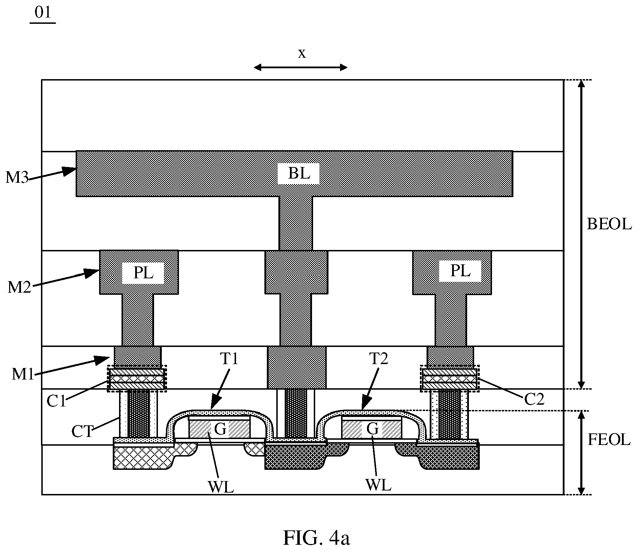

First, a person skilled in the art should understand that, in the field of manufacturing a semiconductor integrated circuit, manufacturing the semiconductor integrated circuit includes a front end of line (front end of line, FEOL) and a back end of line (back end of line, BEOL). For example, for the front end of line, an area (active area) for preparing a transistor is usually obtained through division on a substrate, then ion implantation is performed to implement N-type and P-type areas, then a gate (gate) is manufactured, and then ion implantation is performed again to complete a source (source) and a drain (drain) of each transistor. In other words, the front end of line is to implement manufacturing of the transistor on the substrate. The back end of line corresponding to the front end of line is to establish a plurality of layers of conductive metal lines, and different layers of metal lines are connected through columnar metal vias. Refer to FIG. 4a. A middle end of line is usually disposed between the front end of line (FEOL) and the back end of line (BEOL), and contact holes CTs (contact) are formed in the middle end of line, so as to connect components that are in the front end of line to metal interconnection lines that are in the back end of line.

It may be understood that, in the capacitive memory provided in embodiments of this application, a transistor and a capacitor are disposed in a storage cell. The following specifically describes, based on specific embodiments and disposing of the transistor and the capacitor in the storage cell, the memory provided in embodiments of this application.

First, it should be noted that the following embodiments are described by using an example in which the memory is a FeRAM, the storage cell is of a 1T1C structure, and transistors in two adjacent storage cells share a source (or a drain). However, this application is not limited thereto. In some embodiments, each storage cell may be provided with an independent capacitor and transistor.

For example, refer to FIG. 1. In a storage circuit of the 1T1C structure, gates of transistors T located in a same row are connected to a same word line (WL1, WL2, ...), sources (or drains) of transistors T located in a same column are connected to a same bit line (BL1, BL2, ...), drains (or sources) of the transistors T located in the same row are each connected to one electrode of a capacitor C, and the other electrode of the capacitor C is connected to a same plate line (PL1, PL2, ...).

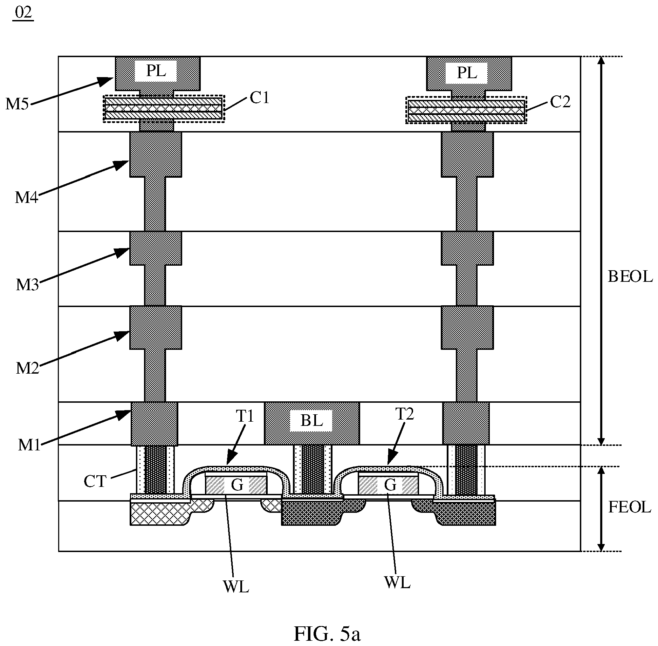

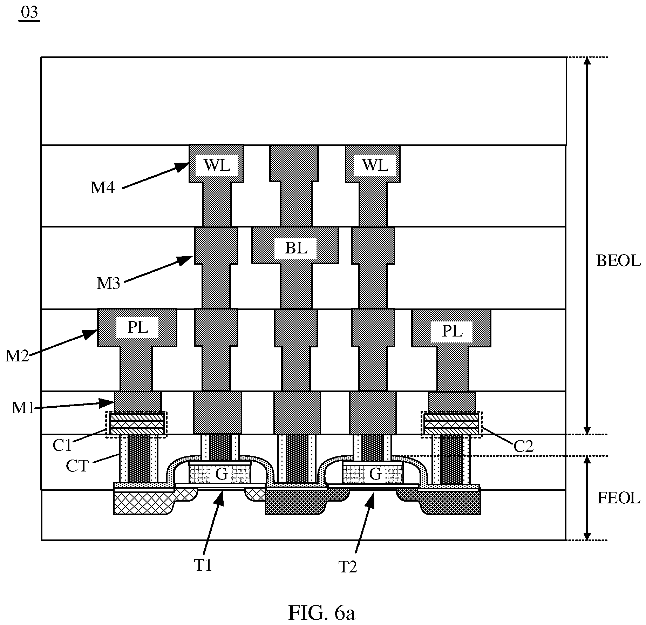

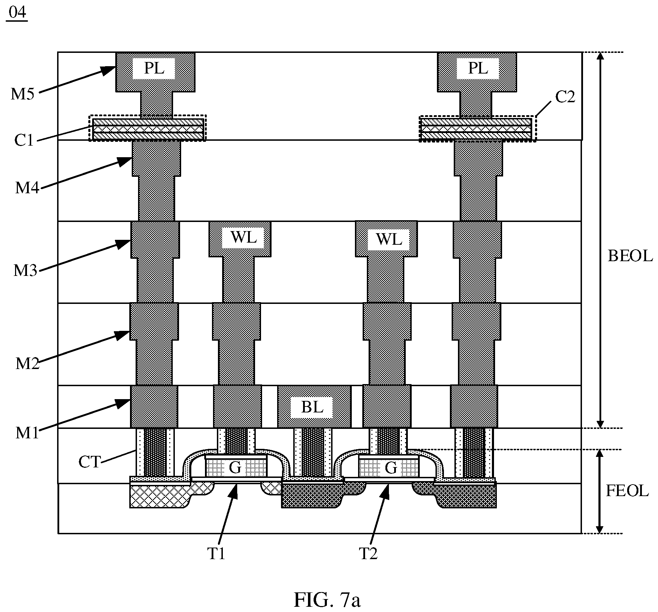

It may be understood herein that, in the FeRAM, the capacitor is a ferroelectric capacitor, and the ferroelectric capacitor includes a bottom electrode, a ferroelectric layer, and a top electrode that are sequentially disposed. The bottom electrode is closer to the substrate than the top electrode. A specific position of the ferroelectric capacitor in the memory may be set based on a requirement. For example, in some possible embodiments, refer to FIG. 4a and FIG. 6a. Ferroelectric capacitors (C1 and C2) may be in a middle end of line, and bottom electrodes of the ferroelectric capacitors (C1 and C2) are directly connected, through contact holes CTs, to components that are in a front end of line. For another example, in some possible implementations, refer to FIG. 5a and FIG. 7a. Ferroelectric capacitors (C1 and C2) may be in a back end of line, and top electrodes of the ferroelectric capacitors (C1 and C2) are directly connected to plate lines PLs.

Based on Embodiment 1 and Embodiment 2, the following describes: For a metal gate-based process node, an area of a storage cell is reduced by directly using gates of transistors to serve as a bit line. In addition, in Embodiment 1 and Embodiment 2, an upper layer or lower layer position relationship of signal lines and a size of a via in a design solution of a minimum storage cell area are described based on different positions of the ferroelectric capacitors.

### Embodiment 1

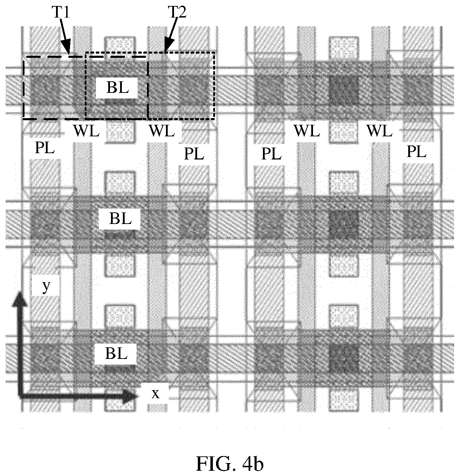

FIG. 4a is a schematic diagram of a structure of a memory according to Embodiment 1. FIG. 4b is a schematic diagram of a layout design of the memory corresponding to FIG. 4a.

Refer to FIG. 4a and FIG. 4b. The memory 01 provided in Embodiment 1 includes a first transistor T1 and a second transistor T2 that are in a front end of line (FEOL), and a first capacitor C1 and a second capacitor C2 are disposed in a middle end of line. The first transistor T1 and the second transistor T2 are disposed in parallel, and the first transistor T1 and the second transistor T2 share a source (or a drain). A non-shared electrode of the source and the drain of the first transistor T1 is electrically connected to a bottom electrode of the first capacitor C1 through a contact hole CT, and a non-shared electrode of the source and the drain of the second transistor T2 is electrically connected to a bottom electrode of the second capacitor C2 through a contact hole CT. In other words, after the first transistor T1 and the second transistor T2 are manufactured in the front end of line (FEOL), the contact holes CTs are formed, in the middle end of line, at positions that correspond to the source and drain of the transistors (T1 and T2), and the capacitors (C1 and C2) are manufactured at positions corresponding to the contact holes CTs.

For ease of description, in this specification, in the sources and the drains of the first transistor T1 and the second transistor T2, the non-shared electrode may be referred to as a "first electrode", and the shared electrode may be referred to as a "second electrode". This is the same for both the "first electrode" and the "second electrode" below, and details are not described again.

In Embodiment 1, the first transistor T1 and the second transistor T2 use metal gates G. In this case, with reference to FIG. 4a and FIG. 4b, word lines (word lines, WLs) connected to the gates G of the transistors (T1 and T2) may be disposed at a metal gate layer. In other words, the word lines WLs and the gates G of the transistors (T1 and T2) are located at a same metal layer, and are of an integrated structure.

For example, as shown in FIG. 4a, a first metal layer M1, a second metal layer M2, and a third metal layer M3 are sequentially disposed in the back end of line (BEOL) of the memory 01 from bottom to top. A bit line BL is disposed in the third metal layer M3, and the second electrode (namely, the shared electrode) of the transistors (T1 and T2) is connected to the bit line BL through a metal via. Plate lines (plate lines, PLs) are disposed in the second metal layer M2, and top electrodes of the first capacitor C1 and the second capacitor C2 are respectively connected to different plate lines PLs through metal vias.

It should be understood herein that, for the plurality of metal layers (M1, M2, and M3) that are sequentially disposed, metal lines are distributed in the metal layers, and a transistor is electrically connected to metal lines through metal vias. In this case, sizes of metal vias enclosed by metal layers in which the metal lines are located and a metal layer between the metal layer in which the metal line is located and the transistor satisfy a design rule (for details, refer to the foregoing descriptions), to ensure an electrical connection effect. For example, when the second electrode (namely, the shared electrode) of the transistors (T1 and T2) are connected to the bit line BL through metal vias, it means that sizes of metal vias enclosed by a metal layer in which the bit line BL is located and metal layers (M1 and M2) below the metal layer need to satisfy the design rule, to ensure an electrical connection between the second electrode of the transistors (T1 and T2) and the bit line BL. This is the same for other similar electrical connection manners in which metal vias are used, and details are not described below.

Refer to FIG. 4a and FIG. 4b. In the design solution of Embodiment 1, the plate lines PLs are located in the metal layer below the bit line BL. For manufacturing the plate line PL, it is necessary to manufacture a metal trench (trench) at a position corresponding to a source/drain of a transistor (similar to manufacturing of a plate line in the following), so that metal lines are arranged densely and with a large area in the metal layer (namely, the second metal layer M2) in which the plate lines PLs are located. Therefore, in an x direction (namely, a width direction of the plate line PL), sizes of the vias enclosed by the second metal layer M2 need to be a minimum size that satisfies the design rule to avoid impact of a spacing, in the design rule, between the metal line and the via on a size of a storage cell. Similarly, in the x direction, sizes of vias enclosed by the first metal layer M1 below the second metal layer M2 need to be a minimum size that satisfies the design rule.

In conclusion, in the related technology in FIG. 3, an area of a storage cell is reduced because a design rule of a word line WL and a via needs to be met. By contrast, in the design solution in Embodiment 1, the word line WL is directly disposed at the metal gate layer, and it is necessary to ensure only that in the x direction, the sizes of the vias enclosed by the first metal layer M1 and the second metal layer M2 satisfy a minimum size of the design rule, so that the area of the storage cell can be reduced, and an area percentage of the ferroelectric capacitor can be increased, thereby implementing high-density storage.

It should be noted that Embodiment 1 is merely described by using an example in which the bit line BL is located at the third metal layer M3 and the plate lines PLs are located at the second metal layer M2. However, this application is not limited thereto, provided that the metal layer in which the plate lines PLs are located is below the metal layer in which the bit line BL is located, and the transistors (T1 and T2) are connected to the capacitors (C1 and C2) through the contact holes CTs. In this case, in the x direction, it is necessary to ensure only that sizes of metal vias enclosed by the metal layer in which the plate lines PLs are located and a metal layer below the metal layer in which the plate lines PLs are located satisfy the minimum size of the design rule. For example, the bit line BL may be disposed at a fourth metal layer (not shown in FIG. 4a), and the plate lines PLs may be disposed at the third metal layer M3.

### Embodiment 2

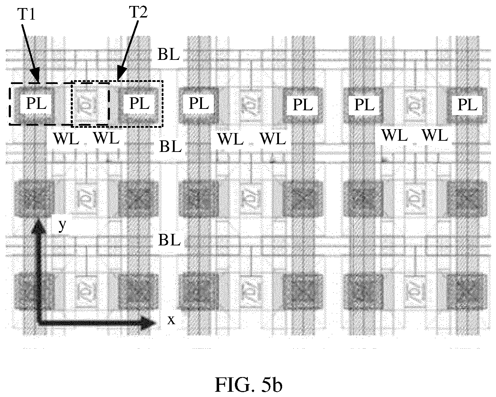

FIG. 5a is a schematic diagram of a structure of a memory according to Embodiment 2 of this application. FIG. 5b is a schematic diagram of a layout design of the memory corresponding to FIG. 5a. Electrical connection relationships between components (such as the T1, T2, C1, C2, WL, PL, and BL) in the memory 01 provided in Embodiment 1 are the same as those in the memory in Embodiment 2, and a difference lies in different inter-layer position relationships.

Refer to FIG. 5a and FIG. 5b. The memory 02 provided in Embodiment 2 is similar to that in Embodiment 1, and a word line WL is also disposed at a same layer as a metal gate G of a transistor. For disposing and related content of a first transistor T1 and a second transistor T2 in the memory 02, refer to the corresponding part in the foregoing Embodiment 1. Details are not described herein again. The following mainly describes differences between the two memories.

For example, as shown in FIG. 5a, in the memory 02, a first capacitor C1 and a second capacitor C2 are disposed in a back end of line (BEOL), and a first metal layer M1, a second metal layer M2, a third metal layer M3, a fourth metal layer M4, and a fifth metal layer M5 are further sequentially disposed in the back end of line (BEOL) from bottom to top. Plate lines PLs are disposed in the fifth metal layer M5, and top electrodes of the first capacitor C1 and the second capacitor C2 are respectively connected to different plate lines PLs through metal vias formed in the fifth metal layer M5. A first electrode (namely, a non-shared electrode) of the first transistor T1 is connected to a bottom electrode of the first capacitor C1 through metal vias, and a first electrode (namely, a non-shared electrode) of the second transistor T2 is connected to a bottom electrode of the second capacitor C2 through metal vias. A bit line BL is disposed in the first metal layer M1, and a second electrode (namely, a shared electrode) of the transistors (T1 and T2) is connected to the bit line BL through a contact hole CT.

Refer to FIG. 5a. In the design solution of Embodiment 2, the metal layer in which the bit line BL is located is below the metal layer in which the plate lines PLs are located, and the plate lines PLs are directly connected to the capacitors (C1 and C2) through the metal vias formed in the metal layer in which the plate lines are located. In this case, the capacitors are located above the bit line BL, sizes of the capacitors are not limited by another metal line, and the plate lines PLs are located in a top layer. Therefore, an advantage of flexible wiring is achieved, without a need to additionally design a size of a via, so that an area of a storage cell can be reduced, and an area percentage of a ferroelectric capacitor can be increased, thereby implementing high-density storage.

It should be noted that Embodiment 2 is merely described by using an example in which the bit line BL is located at the first metal layer M1 and the plate lines PLs are located at the fifth metal layer M5. However, this application is not limited thereto, provided that the metal layer in which the bit line BL is located is below the metal layer in which the plate lines PLs are located, and the plate lines PLs are directly connected to the capacitors (C1 and C2) through the metal vias formed in the metal layer in which the plate lines PLs are located. For example, the plate lines PLs may be disposed at the fourth metal layer M4, and the bit line BL may be disposed at the second metal layer M2.

In Embodiment 3 and Embodiment 4, the following describes: For a polysilicon gate-based process node, an area of a storage cell is reduced by setting a bit line to be connected, through a via, to polysilicon gates of some transistors spaced apart from each other. In addition, in Embodiment 3 and Embodiment 4, an upper layer or lower layer position relationship of signal lines and a size of a via in a design solution of a minimum storage cell area are described based on different positions of the capacitors.

### Embodiment 3

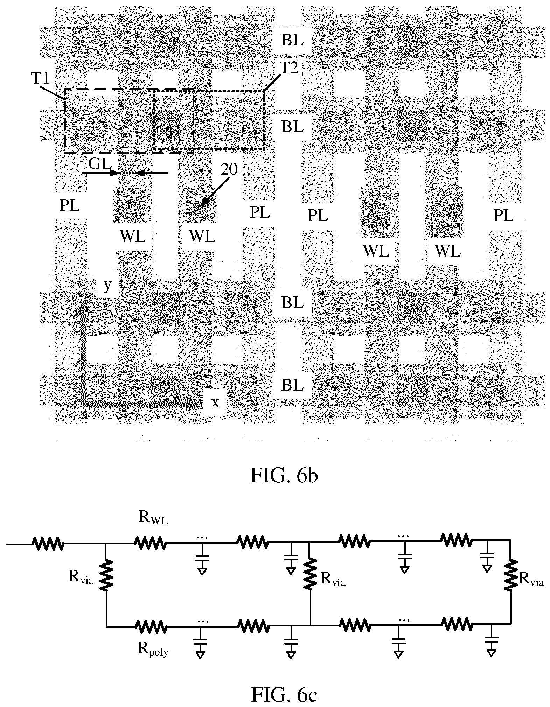

FIG. 6a is a schematic diagram of a structure of a memory according to Embodiment 3 of this application. FIG. 6b is a schematic diagram of a layout design of the memory corresponding to FIG. 6a.

Refer to FIG. 6a and FIG. 6b. Embodiment 3 provides a memory 03. The memory 03 includes a plurality of first transistors T1 and a plurality of second transistors T2 that are in a front end of line (FEOL), and a plurality of first capacitors C1 and a plurality of second capacitors C2 are disposed in a middle end of line. The first transistor T1 and the second transistor T2 are disposed in parallel. A first electrode of the first transistor T1 is electrically connected to a bottom electrode of the first capacitor C1 through a contact hole CT, and a first electrode of the second transistor T2 is electrically connected to a bottom electrode of the second capacitor C1 through a contact hole CT. The first transistor T1 and the second transistor T2 share a second electrode.

In Embodiment 3, gates G made of a polysilicon (poly) material are used for the first transistor T1 and the second transistor T2. In this case, gates G of a plurality of transistors located in a same column are connected through a same signal line. The signal line may be referred to as a gate line GL (referring to FIG. 6b) connection. The gate line GL is a polysilicon line, and the gate line GL and the gates G are of an integrated structure and are located at a same layer.

In addition, with reference to FIG. 6a and FIG. 6b, in the memory 03, a word line WL is disposed at a position that is in a back end of line (BEOL) and that is opposite to the gate line GL. The gate line GL is connected to the gates G through a plurality of metal vias 20 (which may also be referred to as first metal vias), and in a y direction (namely, an extension direction of the word line WL), two adjacent metal vias 20 are spaced by two or more transistors (T1 and T2).

It should be noted herein that quantities of transistors by which any two adjacent first metal vias 20 are spaced may be the same or may be different. For example, some adjacent metal vias 20 may be spaced by 100 transistors, and some other adjacent metal vias 20 may be spaced by 300 transistors. This is not limited in this application. The following embodiments are described by using an example in which quantities of transistors by which any adjacent vias are spaced are the same.

In a related technology, a word line WL is connected to a gate line between every two adjacent transistors through a via. Especially when a size of a transistor is small, a limitation on a spacing between the via and a metal line (for example, a BL) is a main limitation on an area of a storage cell.

In comparison, as shown in FIG. 6b, in this embodiment, the word line WL and the gate line GL are connected through metal vias 20 that are spaced by a plurality of transistors, so that the word line WL and the gate line GL are connected in parallel to serve as a signal line, thereby reducing some vias, and further reducing an area occupied by the some vias in the y direction (namely, the extension direction of the word line), thereby reducing the area of the storage cell.

FIG. 6c shows a parallel equivalent circuit of a word line WL and a gate line GL. In FIG. 6c, Rᵥᵢₐ represents an equivalent resistor at a position of a metal via 20, R_{WL} is an equivalent resistor of a position that corresponds to each transistor and that is of the word line WL, and R_{poly} is an equivalent resistor of a position that corresponds to each transistor and that is of the gate line GL. A node having a highest resistive-capacitive delay (RC delay) in a segment of the sub-circuit is located near a middle position of a segment of a polysilicon gate line. In some specific examples, compared with a delay of the gate line GL made of a polysilicon material, when the metal word line WL is used to be connected in parallel to the gate line GL through the metal vias 20, each time a metal via 20 is added, a resistive-capacitive delay (RC delay) is reduced by about 1/16 times, so that the resistive-capacitive delay (RC delay) can be reduced while an area of a storage cell is reduced.

For example, in some possible implementations, it may be set that two adjacent metal vias 20 are spaced by N transistors. N is less than or equal to 512, and N is an integer. N is set to be less than or equal to 512, so that it can be ensured that the parallel circuit formed by the word line WL and the gate line GL has a small RC delay while the area of the storage cell is reduced.

For example, as shown in FIG. 6a, in Embodiment 3, a first metal layer M1, a second metal layer M2, a third metal layer M3, and a fourth metal layer M4 are sequentially disposed in the back end of line (BEOL) of the memory 03 from bottom to top. Word lines WLs are located at the fourth metal layer M4, and the gate line GL is connected to the word line WL through a plurality of metal vias 20. A bit line BL is disposed in the third metal layer M3, and the second electrode of the first transistor T1 is connected to the bit line BL through metal vias. Plate lines PLs are disposed in the second metal layer M2, and top electrodes of the first capacitor C1 and the second capacitor C2 are respectively connected to different plate lines PLs through metal vias.

In the design solution of Embodiment 3, the plate lines PLs are located at the second metal layer M2, the bit line BL is located at the third metal layer M3, and the word lines WLs are located at the fourth metal layer M4. In this case, metal lines are arranged densely and with a large area in the metal layer (namely, the second metal layer M2) in which the plate lines PLs are located, and sizes of vias enclosed by the second metal layer M2 need to be a minimum size that satisfies a design rule to avoid impact of a spacing, in the design rule, between the metal line and the via on a size of the storage cell. Similarly, in the x direction, sizes of vias enclosed by the first metal layer M1 below the second metal layer M2 need to be a minimum size that satisfies the design rule.

A person skilled in the art may understand that, especially for a transistor of a small size, a limitation on a spacing between a via and a metal line is a main limitation on an area of a storage cell, and the solution in this embodiment is more applicable to reducing the area of the storage cell.

It should be noted that Embodiment 3 is merely described by using an example in which the plate lines PLs are located at the second metal layer M2, the bit line BL is located at the third metal layer M3, and the word lines WLs are located at the fourth metal layer M4. However, this application is not limited thereto, provided that the metal layer in which the plate lines PLs are located is below the metal layer in which the word lines WLs are located, the metal layer in which the bit line BL is located is between the metal layer in which the plate lines PLs are located and the metal layer in which the word lines WLs are located, and the transistors (T1 and T2) are connected to the capacitors (C1 and C2) through the contact holes CTs. In this case, it is necessary to ensure only that sizes of vias enclosed by the metal layer in which the plate lines PLs are located and a metal layer below the metal layer in which the plate lines PLs are located satisfy a minimum size of the design rule.

### Embodiment 4

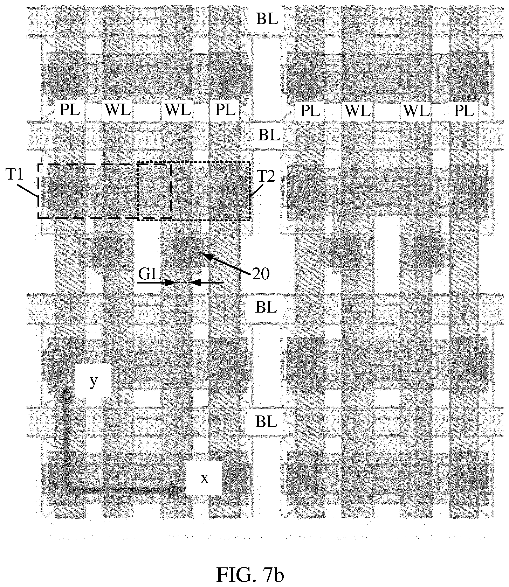

FIG. 7a is a schematic diagram of a structure of a memory 04 according to Embodiment 4 of this application. FIG. 7b is a schematic diagram of a layout design of the memory corresponding to FIG. 7a. Electrical connection relationships between components (such as the T1, T2, C1, C2, WL, PL, and BL) in the memory 03 provided in Embodiment 3 are the same as those in the memory 04 in Embodiment 4, and a difference lies in different inter-layer position relationships.

Refer to FIG. 7a and FIG. 7b. The memory 04 provided in Embodiment 4 is similar to that in Embodiment 3. In the memory 04, a gate line GL and gates G are of an integrated structure formed at a same polysilicon layer. Word lines WLs are located in a back end of line (BEOL), and the gate line GL and the gate line GL are connected through metal vias 20 that are spaced by a plurality of transistors, so that the word line WL and the gate line GL are connected in parallel to serve as a signal line, thereby reducing some vias, and further reducing an area occupied by the some vias in a y direction (namely, an extension direction of the word line), thereby reducing an area of a storage cell.

For disposing and related content of a first transistor T1 and a second transistor T2, refer to the corresponding part in the foregoing Embodiment 3. Details are not described herein again. The following mainly describes differences between the two memories.

For example, as shown in FIG. 7a, in the memory 04, a first capacitor C1 and a second capacitor C2 are disposed in the back end of line (BEOL), and a first metal layer M1, a second metal layer M2, a third metal layer M3, a fourth metal layer M4, and a fifth metal layer M5 are further sequentially disposed in the back end of line (BEOL) from bottom to top. A bit line BL is located at the first metal layer M1, and a second electrode of the transistors (T1 and T2) is connected to the bit line BL through a contact hole CT. The word lines WLs are located at the third metal layer M3, and the gate line GL is connected to the word line WL through a plurality of metal vias 20. Plate lines PLs are located at the fifth metal layer M5, and top electrodes of the first capacitor C1 and the second capacitor C2 are respectively connected to different plate lines PLs through metal vias formed in the fifth metal layer M5. A first electrode (namely, a non-shared electrode) of the first transistor T1 is connected to a bottom electrode of the first capacitor C1 through metal vias, and a first electrode (namely, a non-shared electrode) of the second transistor T2 is connected to a bottom electrode of the second capacitor C2 through metal vias.

Refer to FIG. 7a and FIG. 7b. In the design solution, the bit line BL is located at the first metal layer M1, the word lines WLs are located at the third metal layer M3, and the plate lines PLs are located at the fifth metal layer M5. In this case, in a y direction, the bit line BL, a trench (trench) punched at a position corresponding to a source/drain of a transistor, and the like need to be provided on the first metal layer M1, so that metal lines are arranged densely. Therefore, in the y direction, sizes of vias enclosed by the first metal layer M1 in which the bit line BL is located need to be a minimum size that satisfies a design rule. In an x direction, the word lines WLs and a trench (trench) punched at a position corresponding to the source/drain of the transistor need to be provided on the third metal layer M3. Therefore, in the x direction, sizes of vias enclosed by the third metal layer M3 need to be a minimum size that satisfies the design rule.

It should be noted herein that Embodiment 4 is merely described by using an example in which the bit line BL is located at the first metal layer M1, the word lines WLs are located at the third metal layer M3, and the plate lines PLs are located at the fifth metal layer M5. However, this application is not limited thereto, provided that the metal layer in which the bit line BL is located is below the metal layer in which the plate lines PLs are located, the metal layer in which the word lines WLs are located is between the metal layer in which the bit line BL is located and the metal layer in which the plate lines PLs are located, and the plate lines PLs are directly connected to the capacitors (C1 and C2) through the metal vias formed in the metal layer in which the plate lines PLs are located.

It should be further noted that, for the foregoing Embodiment 2 and Embodiment 4 in which the plate lines PLs are directly connected to the capacitors (C1 and C2) through the metal vias formed in the metal layer in which the plate lines PLs are located, in some possible implementations, as shown in FIG. 5a, the capacitors (C1 and C2) may be disposed in the middle of the metal vias formed in the metal layer (for example, the fifth metal layer M5) in which the plate lines PLs are located. In some possible implementations, as shown in FIG. 7a, the capacitors (C1 and C2) may be disposed below the metal layer in which the plate lines PLs are located.

It should be noted that the foregoing Embodiment 1, Embodiment 2, Embodiment 3, and Embodiment 4 are merely examples. An example in which the transistors (T1 and T2) in two ITIC storage cells share a source (or a drain) is used for description. This application is not limited thereto. For a storage cell in another form, for example, an ITIC storage cell, a 2T2C storage cell, or a 2T1C storage cell that is independently disposed, the design solution in any one of the foregoing embodiments may also be applied, to reduce the area of the storage cell.

In addition, the design solution provided in embodiments of this application satisfies a process structure and a layout design solution of a high-density ferroelectric memory of a general design rule. For the 1T1C storage cell, in the related technology, the technical solution in FIG. 3 is used, an area of the storage cell is about 70F² to 80F², and F is a feature size of a process node. By contrast, according to the design solution in embodiments of this application, an area of the storage cell may be reduced to a minimum value of 36F² to 50F². Certainly, the design solution of this application is applied to a storage cell of another structure such as a 1TnC structure, so that a storage density can be further improved.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, wherein the memory comprises a first transistor that is in a front end of line, and one of a source and a drain of the first transistor is a first electrode and the other is a second electrode;
the memory further comprises a first capacitor and a word line;
the first capacitor is electrically connected to the first electrode of the first transistor; and
the word line and a metal gate of the first transistor are of an integrated structure and are located at a same layer.

2. The memory according to claim 1, wherein
the memory further comprises a plurality of metal layers that are in a back end of line;
the memory is provided with a bit line and a plate line, the bit line and the plate line are distributed at different metal layers of the plurality of metal layers, and a metal layer in which the plate line is located is closer to the front end of line than a metal layer in which the bit line is located;
the second electrode of the first transistor is connected to the bit line through a metal via; and
the first electrode of the first transistor is connected to a bottom electrode of the first capacitor through a contact hole, and a top electrode of the first capacitor is connected to the plate line through a metal via.

3. The memory according to claim 1, wherein
the memory further comprises a plurality of metal layers that are in a back end of line;
the memory is provided with a bit line and a plate line, the bit line and the plate line are distributed at different metal layers of the plurality of metal layers, and a metal layer in which the bit line is located is closer to the front end of line than a metal layer in which the plate line is located;
the second electrode of the first transistor is connected to the bit line through a metal via; and
the plate line is connected to a top electrode of the first capacitor through a metal via formed in the metal layer in which the plate line is located, and the first electrode of the first transistor is connected to a bottom electrode of the first capacitor through a metal via.

4. The memory according to any one of claims 1 to 3, wherein
the memory further comprises a second transistor and a second capacitor;
one of a source and a drain of the second transistor is a first electrode and the other is a second electrode;
the second capacitor is electrically connected to the first electrode of the first transistor; and
the second electrode of the second transistor is the second electrode of the first transistor.

5. A memory, wherein the memory comprises a plurality of first transistors that are in a front end of line and disposed in parallel, and one of a source and a drain of the first transistor is a first electrode and the other is a second electrode;
the memory further comprises a plurality of first capacitors, and a first electrode of each first transistor is connected to one of the first capacitors;
gates of the first transistor are made of a polysilicon material; and the gates of the plurality of first transistors disposed in parallel are connected through a same gate line, and the gate line and the gates of the first transistor are of an integrated structure and are located at a same layer;
the memory is provided with a word line in a back end of line; and
the gate line is connected to the word line through a plurality of first metal vias, two adjacent first metal vias are spaced by N first transistors, and N is a positive integer greater than or equal to 2.

6. The memory according to claim 5, wherein N is less than or equal to 512.

7. The memory according to claim 5 or 6, wherein
the memory further comprises a plurality of metal layers that are sequentially disposed and that are in the back end of line;
the memory is provided with a bit line and a plate line, and the bit line, the plate line, and the word line are distributed at different metal layers of the plurality of metal layers;
a metal layer in which the plate line is located is closer to the front end of line than a metal layer in which the word line is located, and a metal layer in which the bit line is located is between the metal layer in which the plate line is located and the metal layer in which the word line is located;
the second electrode of the first transistor is connected to the bit line through a metal via; and
the first electrode of the first transistor is connected to a bottom electrode of the first capacitor through a contact hole, and a top electrode of the first capacitor is connected to the plate line through a metal via.

8. The memory according to claim 5 or 6, wherein
the memory further comprises a plurality of metal layers that are in the back end of line;
the memory is provided with a bit line and a plate line, and the bit line, the plate line, and the word line are distributed at different metal layers of the plurality of metal layers;
a metal layer in which the bit line is located is closer to the front end of line than a metal layer in which the plate line is located, and a metal layer in which the word line is located is between the metal layer in which the bit line is located and the metal layer in which the plate line is located;
the second electrode of the first transistor is connected to the bit line through a metal via; and
the plate line is connected to a top electrode of the first capacitor through a metal via formed in the metal layer in which the plate line is located, and the first electrode of the first transistor is connected to a bottom electrode of the first capacitor through a metal via.

9. The memory according to any one of claims 6 to 10, wherein
the memory further comprises a second transistor and a second capacitor;
one of a source and a drain of the second transistor is a first electrode and the other is a second electrode;
the second capacitor is electrically connected to the first electrode of the first transistor; and
the second electrode of the second transistor is the second electrode of the first transistor.

10. An electronic device, wherein the electronic device comprises a printed circuit board and the memory according to any one of claims 1 to 9, and the memory is electrically connected to the printed circuit board.
